# FASCICULE DE BREVET EUROPEEN

(11) **EP 2 706 583 B1**
(45) Date de publication et mention de la délivrance du brevet: **13.05.2015**
(21) Numéro de dépôt: 13183709.8
(22) Date de dépôt: 10.09.2013
(51) Int. Cl.: H01L 45/00

(54) **Cellule mémoire à changement de phase**
Phasenwechselspeicherzelle
Phase-change memory cell

(30) Priorité: 10.09.2012 FR 1258472
(43) Date de publication de la demande: 12.03.2014
(73) Titulaire: STMicroelectronics (Crolles 2) SAS, 38920 Crolles (FR); COMMISSARIAT A L'ENERGIE ATOMIQUE ET AUX ENERGIES ALTERNATIVES, 75015 Paris (FR)
(72) Inventeur: Nodin, Jean-François, 38950 Quaix en Chartreuse (FR); Sousa, Véronique, 38000 Grenoble (FR); Lhostis, Sandrine, 38570 Theys (FR)
(74) Mandataire: Thibon, Laurent

(56) Documents cités:
- US-A1- 2010 283 029
- US-A1- 2011 049 456

## Description

### Domaine de l'invention

La présente invention concerne une cellule mémoire à changement de phase couramment appelée dans la technique cellule PCRAM ("Phase-Change Random Access Memory" - mémoire vive à changement de phase). La présente invention concerne également un procédé de fabrication de telles cellules PCRAM.

### Exposé de l'art antérieur

Les mémoires PCRAM utilisent des matériaux dits à changement de phase qui sont capables de passer d'une phase cristalline à une phase amorphe, et inversement, la phase cristalline étant conductrice et la phase amorphe peu conductrice. Ces matériaux à changement de phase sont par exemple des chalcogénures. Les conductivités de la phase cristalline et de la phase amorphe de tels matériaux peuvent être dans un rapport élevé, de 10 ³ à 10⁶.

Les structures existantes de mémoires PCRAM utilisées en mode de programmation multi-niveaux présentent une durée d'écriture élevée.

US 2010/0283029 décrit une cellule mémoire comprenant un via en un matériau à changement de phase disposé entre une électrode inférieure une électrode supérieure, le via comprenant une première région accolée à une deuxième région elle-même accolée à une troisième (et une quatrième) région.

### Résumé

Ainsi, un objet d'un mode de réalisation de la présente invention est de prévoir une cellule PCRAM permettant de réaliser de la programmation multi-niveaux palliant au moins en partie certains des inconvénients des structures existantes de cellules PCRAM.

Un mode de réalisation de la présente invention prévoit une cellule mémoire comprenant un via en un matériau à changement de phase disposé entre une électrode inférieure et une électrode supérieure, le via comprenant une première région accolée à une deuxième région elle-même accolée à au moins une troisième région. Les première, deuxième et troisième régions s'étendant chacune de l'électrode supérieure à l'électrode inférieure, la température de cristallisation de la deuxième région étant comprise entre celle de la première région et celle de la troisième région, et les températures de fusion des première, deuxième et troisième régions étant sensiblement identiques.

Selon un mode de réalisation de la présente invention, la première région est une région centrale du via entourée de la deuxième région elle-même entourée de la troisième région.

Selon un mode de réalisation de la présente invention, le via en matériau à changement de phase a une hauteur comprise entre 30 et 100 nm et des dimensions latérales comprises entre 100 et 300 nm, et les largeurs des première, deuxième et troisième régions sont identiques.

Selon un mode de réalisation de la présente invention, la deuxième région a reçu une implantation de premières espèces et la troisième région a reçu une implantation de deuxièmes espèces.

Selon un mode de réalisation de la présente invention, le matériau à changement de phase est un tellurure de germanium et les premières et deuxièmes espèces sont respectivement de l'azote et du carbone.

Selon un mode de réalisation de la présente invention, le via en matériau à changement de phase est entouré latéralement par un matériau isolant.

Selon un mode de réalisation de la présente invention, une première couche barrière est interposée entre l'électrode inférieure et le matériau à changement de phase, et une seconde couche barrière est interposée entre l'électrode supérieure et le matériau à changement de phase.

Selon un mode de réalisation de la présente invention, le via en matériau à changement de phase comprend en outre au moins une quatrième région accolée à la troisième région, la température de cristallisation de l'au moins une quatrième région étant supérieure à celle de la troisième région, et la température de fusion de l'au moins une quatrième région étant sensiblement identique à celle de la troisième région.

Un mode de réalisation de la présente invention prévoit en outre un procédé de fabrication d'une cellule mémoire, comprenant les étapes consistant à a) former une ouverture dans une couche isolante recouvrant une première électrode formée sur un substrat ; b) remplir l'ouverture d'un matériau à changement de phase pour former un via ; c) implanter des premières espèces dans une deuxième région du via entourant une première région du via et dans une troisième région du via entourant la deuxième région, pour que la température de cristallisation de la deuxième région soit supérieure à celle de la première région et que la température de fusion de la deuxième région soit sensiblement identique à celle de la première région ; d) implanter des deuxièmes espèces seulement dans la troisième région du via pour que la température de cristallisation de la troisième région soit supérieure à celle de la deuxième région et que la température de fusion de la troisième région soit sensiblement identique à celle de la deuxième région ; et e) recouvrir le via d'une seconde électrode.

Selon un mode de réalisation de la présente invention, à l'étape b), l'ouverture est remplie d'un tellurure de germanium ; à l'étape c), de l'azote est implanté dans les deuxième et troisième régions ; et à l'étape d), du carbone est implanté dans la troisième région.

Un mode de réalisation de la présente invention prévoit en outre un procédé d'utilisation d'une cellule mémoire du type de celle décrite ci-dessus, comprenant les étapes successives consistant à rendre amorphe au moins une partie de la première région et au moins une partie des deuxième et troisième régions du via en matériau à changement de phase ; rendre entièrement cristalline la première région ; rendre entièrement cristalline la deuxième région ; et rendre entièrement cristalline la troisième région.

### Brève description des dessins

Ces caractéristiques et avantages, ainsi que d'autres seront exposés en détail dans la description suivante de modes de réalisation particuliers faite à titre non limitatif en relation avec les figures jointes parmi lesquelles :
la figure 1 est une vue en coupe représentant de façon schématique un exemple de cellule PCRAM ;
la figure 2 est une vue en coupe représentant de façon schématique une cellule PCRAM confinée à deux états ;
la figure 3 est une vue en coupe et en perspective représentant de façon schématique une cellule PCRAM confinée multi-niveaux ;
la figure 4 est une vue en coupe représentant de façon schématique une variante d'une cellule PCRAM confinée multi-niveaux ; et
les figures 5A à 5D sont des vues en coupe illustrant de façon schématique des étapes successives d'un procédé de fabrication de la cellule PCRAM confinée multi-niveaux de la figure 4.

Par souci de clarté, de mêmes éléments ont été désignés par de mêmes références dans les différentes figures et, de plus, comme cela est habituel dans la représentation des composants microélectroniques, les diverses figures ne sont pas tracées à l'échelle.

### Description détaillée

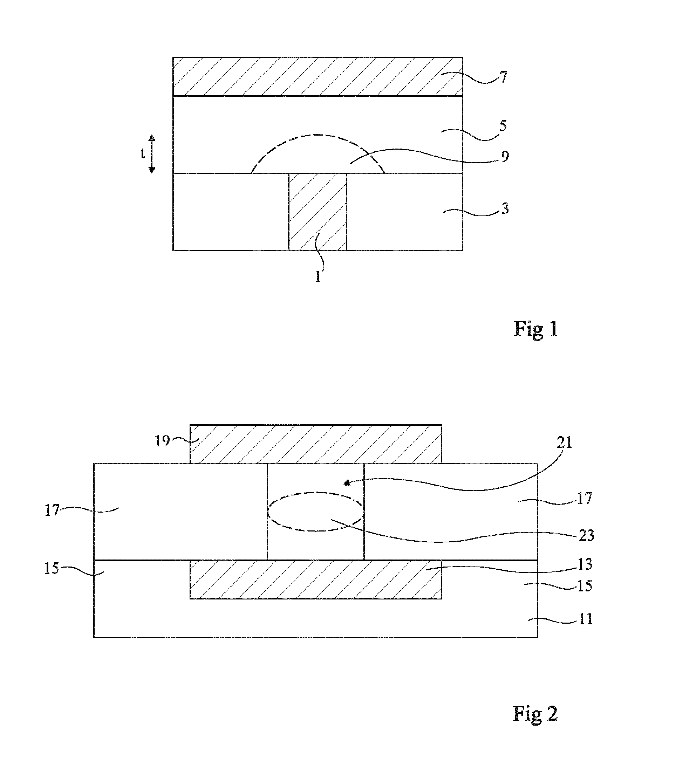

La figure 1 est une vue en coupe représentant de façon schématique un exemple classique de cellule PCRAM.

Sur un substrat non représenté repose une électrode 1 entourée d'un matériau isolant 3. Un matériau à changement de phase 5 recouvre l'électrode 1 et le matériau isolant 3. Le matériau à changement de phase 5 est recouvert d'une électrode 7. Les électrodes 1 et 7 sont de dimensions différentes, l'électrode 1 étant plus étroite que l'électrode 7.

Le fonctionnement d'une telle cellule PCRAM est le suivant.

On considère un état initial dans lequel le matériau à changement de phase 5 est cristallin (conducteur).

Pour passer de cet état conducteur à un état résistif, une impulsion brève de tension élevée est appliquée entre les deux électrodes 1 et 7. Ceci entraîne un échauffement par effet Joule du matériau à changement de phase 5. Le matériau à changement de phase 5 atteint sa température de fusion dans une région 9, délimitée par des pointillés, proche de la plus petite électrode 1. La région 9 du matériau à changement de phase 5 fond puis se refroidit à l'état amorphe (résistif).

Pour passer de l'état résistif à l'état conducteur, une impulsion longue de tension faible est appliquée entre les deux électrodes 1 et 7. Ceci entraîne un échauffement par effet Joule du matériau à changement de phase 5, qui atteint sa température de cristallisation dans la région 9. La région 9 du matériau à changement de phase 5 cristallise et redevient conductrice.

En mode de programmation classique, qui correspond au mode de fonctionnement décrit ci-dessus, seulement deux niveaux de programmation sont utilisés. Un niveau correspond à l'état dit conducteur dans lequel le matériau à changement de phase 5 est entièrement cristallin. L'autre niveau correspond à l'état dit résistif dans lequel une région proche de la plus petite électrode 1 du matériau à changement de phase 5 est amorphe (région 9).

On a aussi proposé de telles cellules PCRAM pouvant être utilisées pour réaliser de la programmation multi-niveaux. Un exemple de telles cellules PCRAM est décrit dans l'article "Multilevel Phase-Change Memory Modeling and Experimental Characterization", A. Pantazi et al., p. 34-41, EPCOS 2009. Des états intermédiaires entre l'état conducteur et l'état résistif sont alors utilisés. En faisant varier l'épaisseur t de la région amorphe 9 du matériau à changement de phase 5, on obtient différentes valeurs de résistance comprises entre la valeur la plus faible correspondant à l'état conducteur et la valeur la plus élevée correspondant à l'état résistif.

Dans une cellule PCRAM du type de celle illustrée en figure 1 utilisée en mode de programmation multi-niveaux, des différences sont observées entre la valeur de résistance obtenue pour un niveau et la valeur à laquelle on aurait dû s'attendre. Ceci peut s'expliquer notamment par des différences dues au procédé de fabrication entre deux cellules conçues pour être identiques, ou par des fluctuations des caractéristiques du matériau à changement de phase dans une même cellule. Les étapes d'écriture et de lecture doivent alors être reprises jusqu'à ce que la valeur de résistance visée soit obtenue. Il en résulte une augmentation de la durée d'écriture.

La figure 2 est une vue en coupe représentant de façon schématique un exemple de cellule PCRAM dite confinée à deux états.

Sur un substrat non représenté, par exemple en silicium, repose une couche isolante 11 revêtue d'une couche conductrice 13 entourée d'un matériau isolant 15. La couche conductrice 13 et le matériau isolant 15 sont recouverts d'une couche isolante 17 elle-même recouverte d'une couche conductrice 19. Un via 21 en un matériau à changement de phase traverse la couche isolante 17 et s'étend de la couche conductrice 19 à la couche conductrice 13.

Les couches conductrices 13 et 19 constituent respectivement les électrodes inférieure et supérieure de la cellule PCRAM. Le via 21 en matériau à changement de phase constitue la zone active de la cellule. Dans une telle cellule PCRAM, les électrodes 13 et 19 sont de même dimension.

Le fonctionnement de cette cellule PCRAM confinée est similaire à celui de la cellule PCRAM illustrée en figure 1, hormis le fait que, si les électrodes 13 et 19 sont de même dimension, la région du matériau à changement de phase 21 qui passe de la phase cristalline à la phase amorphe et inversement, délimitée par des pointillés et désignée par la référence 23, est située sensiblement à égale distance des électrodes 13 et 19. En outre, la région 23 s'étend sur toute la section horizontale du via 21.

Les inventeurs proposent de transformer une cellule PCRAM confinée à deux états du type de celle illustrée en figure 2 en une cellule multi-niveaux. Pour cela, ils prévoient d'implanter des espèces dans le via en matériau à changement de phase de façon à obtenir au moins trois régions adjacentes de températures de cristallisation différentes.

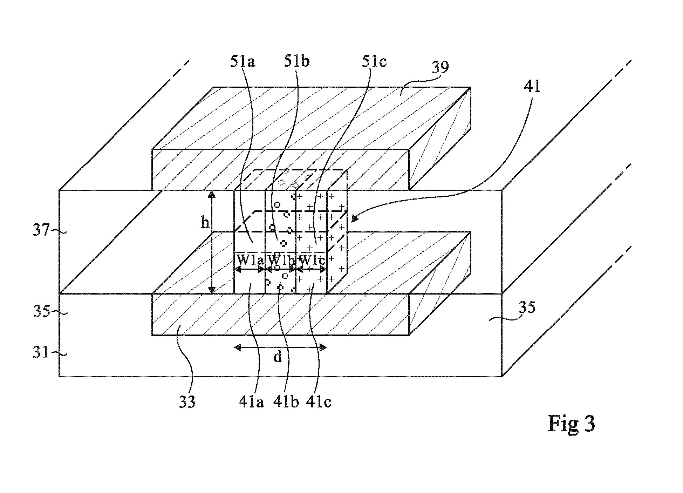

La figure 3 est une vue en coupe et en perspective représentant de façon schématique une cellule PCRAM confinée multi-niveaux.

Sur un substrat non représenté, par exemple en silicium, repose une couche isolante 31 revêtue d'une couche conductrice 33 entourée d'un matériau isolant 35. La couche conductrice 33 et le matériau isolant 35 sont recouverts d'une couche isolante 37 elle-même recouverte d'une couche conductrice 39. Un via 41 en un matériau à changement de phase traverse la couche isolante 37 et s'étend de la couche conductrice 39 à la couche conductrice 33. Les couches conductrices 33 et 39 constituent respectivement les électrodes inférieure et supérieure de la cellule PCRAM. Le via 41 a par exemple une section carrée ou rectangulaire.

Le via 41 en matériau à changement de phase comprend trois régions 41a, 41b et 41c adjacentes, la région 41b étant disposée entre les régions 41a et 41c. Des espèces ont été implantées dans la région 41b de sorte que sa température de cristallisation soit par exemple supérieure à celle de la région 41a. D'autres espèces ont été implantées dans la région 41c de sorte que sa température de cristallisation soit par exemple supérieure à celle de la région 41b. Les espèces ont été implantées de sorte que les températures de fusion des régions 41b et 41c ayant reçu une implantation d'espèces soient sensiblement identiques à celles de la région 41a n'ayant pas reçu d'implantation d'espèces.

Comme cela est représenté, les largeurs respectives W1a, W1b et W1c des régions 41a, 41b et 41c sont par exemple sensiblement identiques.

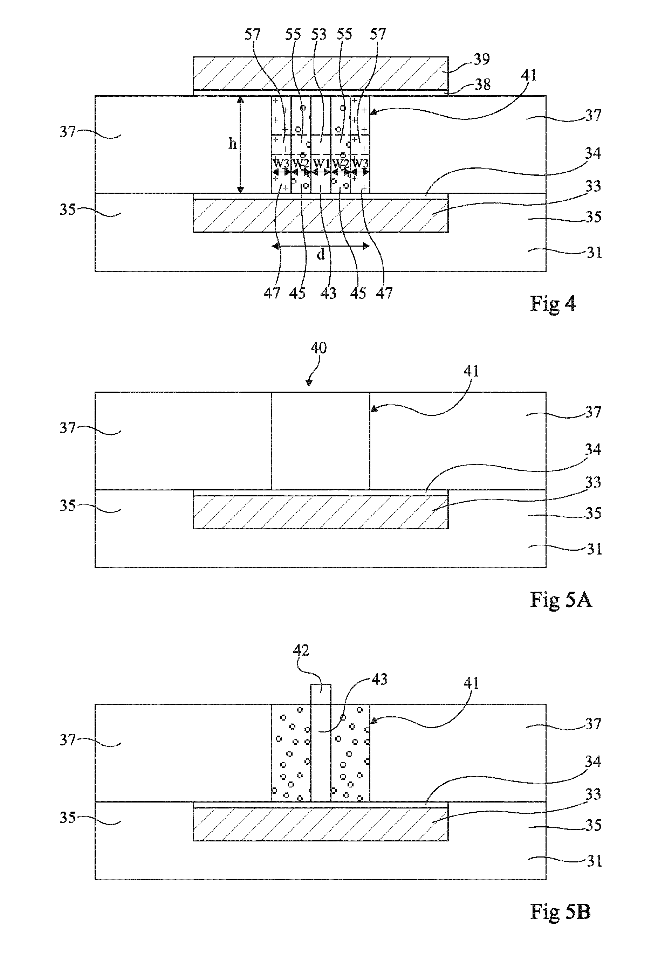

La figure 4 est une vue en coupe représentant de façon schématique une variante de la cellule PCRAM confinée multi-niveaux de la figure 3. Dans cette variante, les inventeurs prévoient d'implanter des espèces dans le via en matériau à changement de phase de façon à obtenir des régions périphériques concentriques entourant une région centrale, la température de cristallisation d'une région périphérique étant supérieure à celle de la région périphérique qu'elle entoure et à celle de la région centrale. Les éléments communs avec ceux de la cellule PCRAM confinée multi-niveaux de la figure 3 sont désignés par les mêmes références.

Dans cette variante, le via 41 en matériau à changement de phase a par exemple une section circulaire, carrée ou rectangulaire. Avantageusement, des couches barrière 34 et 38 sont interposées respectivement entre la couche conductrice 33 et la couche isolante 37 et entre la couche conductrice 39 et la couche isolante 37. Les couches barrière 34 et 38 sont destinées à empêcher la diffusion de métaux des électrodes 33 et 39 vers le matériau à changement de phase 41 et la couche isolante 37. Des couches barrière peuvent également être prévues dans une cellule PCRAM confinée multi-niveaux du type de celle illustrée en figure 3.

Le via 41 en matériau à changement de phase comprend une région centrale 43 entourée par une région périphérique 45 elle-même entourée par une autre région périphérique 47. Des espèces ont été implantées dans la région périphérique 45 de sorte que sa température de cristallisation soit supérieure à celle de la région centrale 43. D'autres espèces ont été implantées dans la région périphérique 47 de sorte que sa température de cristallisation soit supérieure à celle de la région périphérique 45. Les espèces ont été implantées de sorte que les températures de fusion des régions périphériques 45 et 47 soient sensiblement identiques à celle de la région centrale 43.

Comme cela est représenté, les largeurs respectives W1, W2 et W3 de la région centrale 43 et des régions périphériques 45 et 47 sont par exemple sensiblement identiques.

Le fonctionnement d'une cellule PCRAM confinée multi-niveaux du type de celles illustrées en figures 3 et 4 est le suivant.

On considère un état initial dans lequel la région 41a, 43 et les régions 41b, 45 et 41c, 47 du via 41 en matériau à changement de phase sont entièrement cristallines (conductrices).

Pour passer de cet état initial conducteur à un premier état (résistif), une impulsion brève de tension élevée est appliquée entre les deux électrodes 33 et 39, de sorte que la région 41a, 43 et les régions 41b, 45 et 41c, 47 du via 41 atteignent chacune leur température de fusion (qui sont sensiblement identiques). Une portion 51a, 53 de la région 41a, 43, une portion 51b, 55 de la région 41b, 45 et une portion 51c, 57 de la région 41c, 47, situées sensiblement à égale distance des deux électrodes 33 et 39, fondent puis se refroidissent à l'état amorphe. Les portions 51a, 51b, 51c et 53, 55 et 57 qui changent d'état sont délimitées par des pointillés respectivement en figures 3 et 4.

Pour passer de ce premier état résistif à un second état moins résistif, une impulsion longue de tension faible est appliquée entre les deux électrodes 33 et 39, de sorte que la région 41a, 43 du via 41 atteigne sa température de cristallisation, mais pas les régions 41b, 45 et 41c, 47 qui ont une température de cristallisation plus élevée. La portion 51a, 53 de la région 41a, 43 du via 41 cristallise. Dans le second état, la région 41a, 43 du via 41 est entièrement cristalline.

Pour passer de ce second état à un troisième état encore moins résistif, une nouvelle impulsion longue de tension faible est appliquée entre les deux électrodes 33 et 39. La région 41a, 43 du via 41 qui est entièrement cristalline (conductrice) s'échauffe, ce qui entraîne un échauffement de la région 41b, 45 du via 41 en contact avec la région 41a, 43. La région 41b, 45 du via 41 atteint sa température de cristallisation, mais pas la région 41c, 47 qui a une température de cristallisation plus élevée. La portion 51b, 55 de la région 41b, 45 du via 41 cristallise. Dans le troisième état, la région 41a, 43 et la région 41b, 45 du via 41 sont entièrement cristallines.

Pour passer de ce troisième état peu résistif à un quatrième état conducteur, une nouvelle impulsion longue de tension faible est appliquée entre les deux électrodes 33 et 39. La région 41a, 43 et la région 41b, 45 du via 41 qui sont entièrement cristallines (conductrices) s'échauffent, ce qui entraîne un échauffement de la région 41c, 47 du via 41 en contact avec la région 41b, 45. La région 41c, 47 du via 41 atteint sa température de cristallisation. La portion 51c, 57 de la région 41c, 47 du via 41 cristallise. Dans le quatrième état, la région 41a, 43 et les régions 41b, 45 et 41c, 47 du via 41 sont entièrement cristallines. Le via 41 est entièrement cristallin.

Dans une cellule PCRAM confinée multi-niveaux du type de celles illustrées en figures 3 et 4, on obtient quatre niveaux de résistance bien définis correspondant aux quatre états décrits ci-dessus. Il n'est donc pas nécessaire de reprendre les étapes d'écriture et de lecture pour vérifier que la valeur de résistance visée est atteinte.

L'homme de l'art saura choisir les largeurs W1 (W1a), W2 (W1b) et W3 (W1c) des régions 43 (41a), 45 (41b) et 47 (41c) pour obtenir quatre niveaux de résistance bien définis.

Un avantage d'une cellule PCRAM confinée multi-niveaux du type de celles illustrées en figures 3 et 4 réside dans son fonctionnement simple en mode de programmation multi-niveaux.

A titre d'exemple de matériaux et de dimensions, les électrodes 33 et 39 sont par exemple en siliciure d'aluminium (AlSi) et ont par exemple une épaisseur comprise entre 50 et 500 nm. Les couches barrière sont par exemple en nitrure de titane (TiN) et ont par exemple une épaisseur comprise entre 5 et 50 nm. Les couches isolantes 31, 35 et 37 sont par exemple en oxyde de silicium.

L'épaisseur de la couche isolante 37, et donc la hauteur h du via 41, est par exemple comprise entre 30 et 100 nm, par exemple de l'ordre de 50 nm. Les dimensions latérales d du via 41 (le diamètre d du via 41 dans le cas où le via a une section circulaire) sont par exemple comprises entre 100 et 300 nm, par exemple de l'ordre de 150 nm.

Dans le cas d'une cellule PCRAM confinée multi-niveaux du type de celle illustrée en figure 4, pour un via 41 de diamètre d compris entre 100 et 300 nm, les largeurs W1, W2 et W3 sont par exemple comprises entre 20 et 60 nm.

Selon un exemple de réalisation, le matériau à changement de phase 41 est un tellurure de germanium, par exemple du Ge_{0,5}Te_{0,5}, et sa température de cristallisation est d'environ 180°C. La région 41b, 45 a reçu une implantation d'azote et sa température de cristallisation est d'environ 275°C. La région 41c, 47 a reçu une implantation de carbone et sa température de cristallisation est d'environ 370°C.

Les figures 5A à 5D sont des vues en coupe illustrant de façon schématique des étapes successives d'un procédé de fabrication d'une cellule PCRAM confinée multi-niveaux du type de celle illustrée en figure 4.

La figure 5A représente la couche isolante 31 (reposant sur un substrat non représenté) revêtue de la couche conductrice 33, par exemple en AlSi, elle-même revêtue de la couche barrière 34, par exemple en TiN. Les couches 33 et 34 sont entourées du matériau isolant 35. La couche conductrice 33 constitue l'électrode inférieure de la cellule PCRAM confinée multi-niveaux en cours de formation.

La couche barrière 34 et le matériau isolant 35 ont été recouverts de la couche isolante 37. Une ouverture 40 a été formée dans la couche isolante 37, à partir de la surface supérieure de la couche isolante 37 jusqu'à la couche barrière 34. L'ouverture 40 a été remplie d'un matériau à changement de phase, par exemple un tellurure de germanium, par exemple du Ge_{0,5}Te_{0,5}, pour former le via 41. Pour cela, le matériau à changement de phase a par exemple été déposé par un procédé PVD. Un polissage physico-chimique de type CMP ("Chemical Mechanical Polishing") a par exemple ensuite été effectué, de sorte que la surface supérieure du via 41 en matériau à changement de phase affleure au même niveau que la surface supérieure de la couche isolante 37.

En figure 5B, des espèces ont été implantées dans le via 41 en matériau à changement de phase, excepté dans une région centrale 43 du via 41. Pour cela, un masque 42 a été préalablement disposé au-dessus de la région centrale 43 du via 41. Les espèces et les conditions d'implantation sont choisies de sorte que, après implantation, la température de cristallisation de la région centrale 43 du via 41 soit inférieure à celle du reste du via 41, et de sorte que la température de fusion de la région centrale 43 soit sensiblement identique à celle du reste du via 41. Les espèces implantées sont par exemple de l'azote.

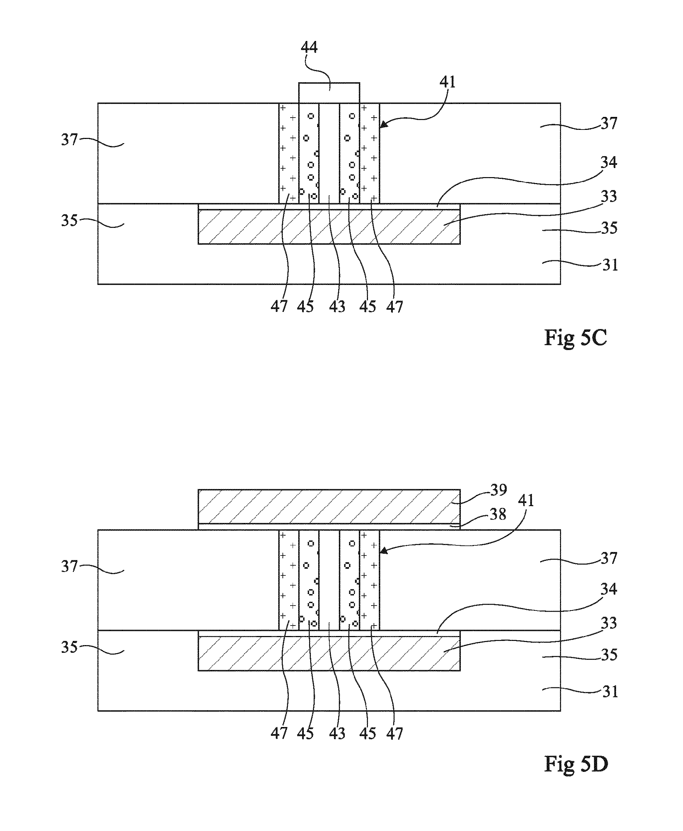

En figure 5C, d'autres espèces ont été implantées dans la région périphérique 47 du via 41. Pour cela, un masque 44 a été préalablement disposé au-dessus de la région centrale 43 et au-dessus de la région périphérique 45 du via 41 entourant la région centrale 43 dans lesquelles on ne veut pas implanter d'espèces. Les espèces et les conditions d'implantation sont choisies de sorte que, après implantation, la température de cristallisation de la région périphérique 47 soit supérieure à celle de la région périphérique 45 qui est elle-même supérieure à celle de la région centrale 43, et de sorte que la température de fusion de la région périphérique 47 soit sensiblement identique à celles de la région périphérique 45 et de la région centrale 43. Les espèces implantées sont par exemple du carbone.

En figure 5D, un empilement constituée de la couche barrière 38, par exemple en TiN, et de la couche conductrice 39, par exemple en AlSi, a été formé au-dessus du via 41 en matériau à changement de phase et au-dessus de portions de la couche isolante 37 entourant le via 41. La couche conductrice 39 constitue l'électrode supérieure de la cellule PCRAM confinée multi-niveaux.

Un procédé similaire pourra être utilisé pour fabriquer une cellule PCRAM confinée multi-niveaux du type de celle illustrée en figure 3. L'homme du métier saura utiliser des masques adaptés pour former les régions 41a, 41b et 41c de températures de cristallisation différentes.

Des modes de réalisation particuliers de la présente invention ont été décrits. Diverses variantes et modifications apparaîtront à l'homme de l'art.

En particulier, bien que l'on ait décrit une cellule PCRAM confinée multi-niveaux comprenant un via en un tellurure de germanium, tout matériau à changement de phase dont la température de cristallisation peut être augmentée par implantation d'espèces tout en conservant sensiblement la même température de fusion peut être utilisé.

En outre, bien que l'on ait décrit deux variantes d'une cellule PCRAM confinée multi-niveaux dont le via en matériau à changement de phase comprend une première région accolée à une deuxième région elle-même accolée à une troisième région, le via en matériau à changement de phase pourra bien entendu comprendre plus de trois régions de températures de cristallisation différentes. Ainsi, la cellule PCRAM confinée multi-niveaux sera adaptée à la programmation de plus de quatre états, correspondant à plus de quatre niveaux de résistance bien définis.

Bien que l'on ait décrit une cellule PCRAM confinée multi-niveaux dont le via en matériau à changement de phase comprend une première région accolée à une deuxième région elle-même accolée à une troisième région, la température de cristallisation de la deuxième région étant comprise entre celle de la première région et celle de la troisième région, les températures de cristallisation des première, deuxième et troisième régions peuvent être réparties dans un autre ordre.

## Revendications

1. Cellule mémoire comprenant un via (41) en un matériau à changement de phase disposé entre une électrode inférieure (33) et une électrode supérieure (39), dans laquelle le via comprend une première région (41a, 43) accolée à une deuxième région (41b, 45) elle-même accolée à au moins une troisième région (41c, 47), **caractérisé en ce que** les première, deuxième et troisième régions s'étendent chacune de l'électrode supérieure à l'électrode inférieure, et **en ce que** la température de cristallisation de la deuxième région est comprise entre celle de la première région et celle de la troisième région, et les températures de fusion des première, deuxième et troisième régions sont sensiblement identiques.

2. Cellule mémoire selon la revendication 1, dans laquelle la première région est une région centrale (43) du via (41) entourée de la deuxième région (45) elle-même entourée de la troisième région (47).

3. Cellule mémoire selon la revendication 1 ou 2, dans laquelle le via en matériau à changement de phase (41) a une hauteur (h) comprise entre 30 et 100 nm et des dimensions latérales (d) comprises entre 100 et 300 nm, et dans laquelle les largeurs (Wla, Wlb, W1c ; W1, W2, W3) des première (41a, 43), deuxième (41b, 45) et troisième (41c, 47) régions sont identiques.

4. Cellule mémoire selon l'une quelconque des revendications 1 à 3, dans laquelle la deuxième région (41b, 45) a reçu une implantation de premières espèces et dans laquelle la troisième région (41c, 47) a reçu une implantation de deuxièmes espèces.

5. Cellule mémoire selon la revendication 4, dans laquelle le matériau à changement de phase (41) est un tellurure de germanium et dans laquelle les premières et deuxièmes espèces sont respectivement de l'azote et du carbone.

6. Cellule mémoire selon l'une quelconque des revendications 1 à 5, dans laquelle le via (41) en matériau à changement de phase est entouré latéralement par un matériau isolant (37).

7. Cellule mémoire selon l'une quelconque des revendications 1 à 6, dans laquelle une première couche barrière (34) est interposée entre l'électrode inférieure (33) et le matériau à changement de phase (41), et dans laquelle une seconde couche barrière (38) est interposée entre l'électrode supérieure (39) et le matériau à changement de phase (41).

8. Cellule mémoire selon l'une quelconque des revendications 1 à 7, dans laquelle le via (41) en matériau à changement de phase comprend en outre au moins une quatrième région accolée à la troisième région, la température de cristallisation de l'au moins une quatrième région étant supérieure à celle de la troisième région, et la température de fusion de l'au moins une quatrième région étant sensiblement identique à celle de la troisième région.

9. Procédé de fabrication d'une cellule mémoire, comprenant les étapes suivante :
a) former une ouverture (40) dans une couche isolante (37) recouvrant une première électrode (33) formée sur un substrat ;
b) remplir l'ouverture d'un matériau à changement de phase pour former un via (41) ;
c) implanter des premières espèces dans une deuxième région (45) du via entourant une première région (43) du via et dans une troisième région (47) du via entourant la deuxième région, pour que la température de cristallisation de la deuxième région soit supérieure à celle de la première région et que la température de fusion de la deuxième région soit sensiblement identique à celle de la première région ;
d) implanter des deuxièmes espèces seulement dans la troisième région du via pour que la température de cristallisation de la troisième région soit supérieure à celle de la deuxième région et que la température de fusion de la troisième région soit sensiblement identique à celle de la deuxième région ; et
e) recouvrir le via d'une seconde électrode (39).

10. Procédé selon la revendication 9, dans lequel :
à l'étape b), l'ouverture (40) est remplie d'un tellurure de germanium ;
à l'étape c), de l'azote est implanté dans les deuxième (45) et troisième (47) régions ; et
à l'étape d), du carbone est implanté dans la troisième région.

11. Procédé d'utilisation d'une cellule mémoire selon l'une quelconque des revendications 1 à 8, comprenant les étapes successives suivantes :
rendre amorphe au moins une partie (51a, 53) de la première région (41a, 43) et au moins une partie (51b, 51c ; 55, 57) des deuxième (41b, 45) et troisième (41c, 47) régions du via (41) en matériau à changement de phase ;
rendre entièrement cristalline la première région ;
rendre entièrement cristalline la deuxième région ; et
rendre entièrement cristalline la troisième région.

## Patentansprüche

1. Eine Speicherzelle, die eine Via (41) aus einem Phasenänderungsmaterial angeordnet zwischen einer unteren Elektrode (33) und einer oberen Elektrode (39) aufweist, wobei die Via eine erste Zone (41 a, 43) benachbart zu einer zweiten Zone (41 b, 45) aufweist, wobei diese benachbart zu mindestens einer dritten Zone (41 c, 47) ist, **dadurch gekennzeichnet, dass** jede der ersten, zweiten und dritten Zonen sich von der oberen Elektrode zu der unteren Elektrode erstreckt, wobei die Kristallisationstemperatur der zweiten Zone im Bereich zwischen der Kristallisationstemperatur der ersten Zone und der der dritten Zone liegt, und wobei die Schmelztemperaturen der ersten, zweiten und dritten Zonen im Wesentlichen identisch sind.

2. Die Speicherzelle nach Anspruch 1, wobei die erste Zone eine Mittelzone (43), der Via (41) ist, und zwar umgeben von der zweiten Zone (45), die ihrerseits von der dritten Zone (47) umgeben ist.

3. Die Speicherzelle nach Anspruch 1 oder 2, wobei die Via, hergestellt aus einem Phasenänderungsmaterial (41, 51) eine Höhe (h) besitzt, die im Bereich zwischen 30 und 100 nm liegt, und seitliche Dimensionen (d) aufweist, die im Bereich zwischen 100 und 300 nm liegen, und wobei die Breiten (W1 a, W1 b, W1 c; W1, W2, W3) der ersten (41 a, 43), der zweiten (41 b, 45), und der dritten (41 c, 47) Zonen identisch sind.

4. Die Speicherzelle nach einem der Ansprüche 1 bis 3, wobei die zweite Zone (41 b, 45) eine Implantation erster Spezies erhalten hat, und wobei die dritte Zone (41 c, 47) eine Implantation zweiter Spezies erhalten hat.

5. Die Speicherzelle nach Anspruch 4, wobei das Phasenänderungsmaterial (41), ein Germanium-Tellurid ist, und wobei die ersten und zweiten Spezies Stickstoff bzw. Karbon sind.

6. Die Speicherzelle nach einem der Ansprüche 1 bis 5, wobei die Via aus Phasenänderungsmaterial (41) seitlich mit einem Isoliermaterial (37) umgeben ist.

7. Die Speicherzelle nach einem der Ansprüche 1 bis 6, wobei eine erste Barrierenschicht (34) zwischen der unteren Elektrode (33) und dem Phasenänderungsmaterial (41) angeordnet ist, und wobei eine zweite Barrierenschicht (38) zwischen der oberen Elektrode (39) und dem Phasenänderungsmaterial (41) angeordnet ist.

8. Die Speicherzelle nach einem der Ansprüche 1 bis 7, wobei die Via (41) hergestellt aus Phasenänderungsmaterial ferner mindestens eine vierte Zone benachbart zur dritten Zone aufweist, wobei die Kristallisationstemperatur der mindestens einen vierten Zone höher ist, als die Kristallisationstemperatur der dritten Zone und wobei die Schmelztemperatur der mindestens einen vierten Zone im Wesentlichen identisch zu der Schmelztemperatur der dritten Zone ist.

9. Ein Verfahren zur Herstellung einer Speicherzelle, welches die folgenden Schritte aufweist:
a) Formen einer Öffnung (40) in einer Isolationsschicht (37), die eine erste Elektrode (33) geformt auf einem Substrat abdeckt;
b) Füllen der Öffnung mit einem Phasenänderungsmaterial um eine Via (41) zu bilden;
c) Implantieren erster Spezies in einer zweiten Zone (45) der Via, die eine erste Zone (43) der Via umgibt, und in einer dritten Zone (47) der Via, die die zweite Zone umgibt, so dass die Kristallisationstemperatur der zweiten Zone höher ist als die der ersten Zone und dass die Schmelztemperatur der zweiten Zone im Wesentlichen identisch zu der Schmelztemperatur der ersten Zone ist;
d) Implantieren zweiter Spezies nur in der dritten Zone der Via, so dass die Kristallisationstemperatur der dritten Zone größer ist als die Kristallisationstemperatur der zweiten Zone, und dass die Schmelztemperatur der dritten Zone im Wesentlichen identisch zu der Schmelztemperatur der zweiten Zone ist; und
e) Abdecken der Via mit einer zweiten Elektrode (39).

10. Das Verfahren nach Anspruch 9, wobei:
beim Schritt b) die Öffnung (40) mit einem Germanium-Tellurid gefüllt wird;
beim Schritt c) Stickstoff in die zweite (45) und in die dritte (47) Zonen implantiert wird; und
beim Schritt d) Kohlenstoff in die dritte Zone implantiert wird.

11. Ein Verfahren zur Verwendung der Speicherzelle irgendeines der Ansprüche 1 bis 8, wobei die aufeinanderfolgenden Schritte vorgesehen sind:
Amorph-Machen mindestens eines Teils (51 a, 53) der ersten Zone (41 a, 43) und mindestens eines Teils (51 b, 51 c; 55, 57) der zweiten (41 b, 45) und dritten (41 c, 47) Zonen der Via (41) hergestellt aus Phasenänderungsmaterial;
vollständiges Kristallin-Machen der ersten Zone;
vollständiges Kristallin-Machen der zweiten Zone; und
vollständiges Kristallin-Machen der dritten Zone.

## Claims

1. A memory cell comprising a via (41) made of a phase-change material arranged between a lower electrode (33) and an upper electrode (39), wherein the via comprises a first region (41a, 43) adjacent to a second region (41b, 45) itself adjacent to at least one third region (41c, 47), **characterized in that** each of the first, second, and third regions extends from the upper electrode to the lower electrode, the crystallization temperature of the second region ranges between that of the first region and that of the third region, and the melting temperatures of the first, second, and third regions are substantially identical.

2. The memory cell of claim 1, wherein the first region is a central region (43) of the via (41) surrounded with the second region (45), itself surrounded with the third region (47).

3. The memory cell of claim 1 or 2, wherein the via made of a phase-change material (41, 51) has a height (h) ranging between 30 and 100 nm and lateral dimensions (d) ranging between 100 and 300 nm, and wherein the widths (W1a, W1b, W1c; W1, W2, W3) of the first (41a, 43), second (41b, 45), and third (41c, 47) regions are identical.

4. The memory cell of any of claims 1 to 3, wherein the second region (41b, 45) has received an implantation of first species and wherein the third region (41c, 47) has received an implantation of second species.

5. The memory cell of claim 4, wherein the phase-change material (41) is a germanium telluride and wherein the first and second species respectively are nitrogen and carbon.

6. The memory cell of any of claims 1 to 5, wherein the via made of phase-change material (41) is laterally surrounded with an insulating material (37).

7. The memory cell of any of claims 1 to 6, wherein a first barrier layer (34) is interposed between the lower electrode (33) and the phase-change material (41), and wherein a second barrier layer (38) is interposed between the upper electrode (39) and the phase-change material (41).

8. The memory cell of any of claims 1 to 7, wherein the via (41) made of phase-change material further comprises at least one fourth region adjacent to the third region, the crystallization temperature of the at least one fourth region being higher than that of the third region, and the melting temperature of the at least one fourth region being substantially identical to that of the third region.

9. A method for manufacturing a memory cell, comprising the steps of:
a) forming an opening (40) in an insulating layer (37) covering a first electrode (33) formed on a substrate;
b) filling the opening with a phase-change material to form a via (41);
c) implanting first species in a second region (45) of the via surrounding a first region (43) of the via and in a third region (47) of the via surrounding the second region, so that the crystallization temperature of the second region is higher than that of the first region and that the melting temperature of the second region is substantially identical to that of the first region;
d) implanting second species only in the third region of the via so that the crystallization temperature of the third region is greater than that of the second region and that the melting temperature of the third region is substantially identical to that of the second region; and
e) covering the via with a second electrode (39).

10. The method of claim 9, wherein:
at step b), the opening (40) is filled with a germanium telluride;
at step c), nitrogen is implanted in the second (45) and third (47) regions; and
at step d), carbon is implanted in the third region.

11. A method for using the memory cell of any of claims 1 to 8, comprising the successive steps of:
making amorphous at least a portion (51a, 53) of the first region (41a, 43) and at least a portion (51b, 51c; 55, 57) of the second (41b, 45) and third (41c, 47) regions of the via (41) made of phase-change material;
making the first region totally crystalline;
making the second region totally crystalline; and
making the third region totally crystalline.
